# FASCICULE DE BREVET EUROPEEN

(11) **EP 3 201 641 B1**
(45) Date de publication et mention de la délivrance du brevet: **18.03.2020**
(21) Numéro de dépôt: 15778897.7
(22) Date de dépôt: 29.09.2015
(51) Int. Cl.: G01R 31/327, G01R 31/02, G01R 31/08, G01R 31/00, G01R 31/42

(54) **PROCEDE D'IDENTIFICATION DE L'EXISTENCE D'UNE PANNE, PROCEDE D'IDENTIFICATION D'UN EQUIPEMENT RELAIS EN PANNE, PROCEDE D'IDENTIFICATION DU TYPE DE PANNE ET SYSTEME D'ALIMENTATION ASSOCIE**
VERFAHREN ZUR ERKENNUNG DES VORHANDENSEINS EINES FEHLERS, VERFAHREN ZUR ERKENNUNG EINER FEHLERHAFTEN RELAISVORRICHTUNG, VERFAHREN ZUR ERKENNUNG DER ART VON FEHLER UND ZUGEHÖRIGES STROMVERSORGUNGSSYSTEM
METHOD FOR IDENTIFYING THE EXISTENCE OF A FAILURE, METHOD FOR IDENTIFYING A FAILED RELAY DEVICE, METHOD FOR IDENTIFYING THE TYPE OF FAILURE AND ASSOCIATED POWER SUPPLY SYSTEM

(30) Priorité: 30.09.2014 FR 1459250
(43) Date de publication de la demande: 09.08.2017
(73) Titulaire: Safran Electronics & Defense, 92100 Boulogne-Billancourt (FR)
(72) Inventeur: BOCAGE, Frédéric, F-92100 Boulogne-Billancourt (FR)
(74) Mandataire: Plasseraud IP
(86) Numéro de dépôt international: PCT/EP2015/072380
(87) Numéro de publication internationale: WO 2016/050745

(56) Documents cités:
- WO-A1-00/39597
- US-A1- 2012 112 651
- US-A1- 2013 221 973
- US-A1- 2013 278 072
- KEZUNOVIC M ET AL: "DESIGN, IMPLEMENTATION AND VALIDATION OF A REAL-TIME DIGITAL SIMULATOR FOR PROTECTION RELAY TESTING", IEEE TRANSACTIONS ON POWER DELIVERY, IEEE SERVICE CENTER, NEW YORK, NY, US, vol. 11, no. 1, 1 janvier 1996 (1996-01-01), pages 158-164, XP011049065, ISSN: 0885-8977
- KHANNICHE M S ET AL: "Real time hysteresis controller for relay testing", IEE PROCEEDINGS: ELECTRIC POWER APPLICATIONS, INSTITUTION OF ELECTRICAL ENGINEERS, GB, vol. 141, no. 2, 1 mars 1994 (1994-03-01), pages 71-6, XP006001752, ISSN: 1350-2352, DOI: 10.1049/IP-EPA:19949855

## Description

L'invention concerne un procédé d'identification d'un équipement relais en panne dans un système d'alimentation électrique propre à alimenter un dispositif par transmission d'un signal d'alimentation entre un générateur de puissance, au moins un équipement relais et le dispositif à alimenter. Ce procédé permet d'identifier si un équipement relais est en panne et quel est le type de panne parmi un nombre prédéfini de pannes typiques. Si le système d'alimentation comporte plusieurs équipements relais, le procédé selon l'invention permet d'identifier quel est l'équipement relais en panne.

Un tel système d'alimentation peut, par exemple, être utilisé pour alimenter un capteur de pression dans un véhicule de transport de passagers, de type avion ou train.

Il existe de nombreuses méthodes permettant d'identifier l'existence d'une panne.

Une méthode d'identification de l'équipement relais en panne connue consiste à rajouter des éléments actifs dans les différents équipements relais. Ces éléments actifs réalisent un autodiagnostic de panne et communiquent cette information au calculateur.

L'utilisation de cette méthode exige que du personnel au sol vérifie régulièrement, par exemple à chaque escale, que les batteries alimentant ces éléments actifs soient chargées afin de les charger si nécessaire. Cette vérification est coûteuse et peut augmenter le temps d'immobilisation au sol de l'avion. L'utilisation de cette méthode exige également la mise en place d'une électronique complexe (au minimum une alimentation et un circuit de traitement) ce qui pose des problèmes en termes d'intégration mécanique (encombrement réduit), de fiabilité (dégradation de la disponibilité de l'équipement du fait de cette électronique additionnelle) et de tenue en température de cette électronique additionnelle.

Une autre méthode d'identification de l'équipement relais en panne connue consiste à mesurer l'amplitude du courant et l'amplitude de la tension du signal émis en sortie du calculateur vers le dispositif à alimenter. L'amplitude de la tension est comparée à un seuil de tension maximal et à un seuil de tension minimal. De même, l'amplitude de courant est comparée à un seuil de courant maximal et à un seuil de courant minimal. Ces comparaisons permettent de déterminer l'équipement relais en panne.

Cette méthode présente également des limites.

Tout d'abord, cette méthode présente une sensibilité importante aux caractéristiques du câble utilisé et notamment à sa longueur. Or, les tolérances de fabrication des pièces font que la longueur du câble peut varier d'un avion à l'autre, ou entre les équipements, d'une quantité suffisante pour provoquer une détection d'une panne inexistante ou au contraire, et cela est plus dangereux, pour ne pas détecter la présence d'une panne. Si, de plus, l'avionneur décide de modifier le diamètre, la longueur du câble ou de déplacer le premier équipement relais après la détermination des seuils, ces seuils maximal et minimal ne sont plus corrects et doivent être déterminés une nouvelle fois. Or, cette détermination nécessite de nombreux tests qui peuvent durer quelques mois, et le logiciel embarqué étant certifié (cas aéronautique), un rebond de certification peut s'avérer nécessaire. Cette méthode est très coûteuse.

Ensuite, cette méthode est non applicable dans une structure dans laquelle un calculateur unique de gestion de tous les capteurs du véhicule est remplacé par plusieurs calculateurs et générateurs de puissance, tous identiques, répartis dans le véhicule de transport et dans laquelle chacun de ses multiples calculateurs ne connaît pas sa position dans le véhicule donc la longueur des câbles le reliant aux différents dispositifs à alimenter. En conséquence, des mesures d'amplitude de courant et d'amplitude de tension identiques pourront avoir des significations complètement différentes quant au fonctionnement et/ou à l'identification de l'équipement relais en panne en fonction de la position du calculateur dans le véhicule de transport. Cette méthode ne permet pas une identification de l'équipement en panne dans une telle structure.

Par ailleurs, la variabilité des composants électroniques du calculateur, incluant l'étage générant le signal à émettre sur le câble et l'étage de mesure de l'amplitude de la tension et du courant, est à prendre en compte dans la définition des seuils. Par exemple, la variabilité des différents gains de la fonction électronique (induite par la tolérance des composants électroniques utilisés) entraine une variabilité des résultats de mesure obtenus pour une configuration d'un dispositif à alimenter donné. En conséquence, les marges allouées à l'identification de la nature du dispositif à alimenter sont réduites.

Le document US 2013/0221973 décrit une sonde de mesure de panne d'un dispositif à alimenter. Le document US 2013/278072 décrit un système de transfert d'énergie par résonnance.

Le but de la présente invention est de proposer un procédé d'identification d'un équipement relais en panne dans un système d'alimentation utilisant des équipements relais passifs. Ce procédé peut être mis en œuvre sans une connaissance précise des caractéristiques et de la longueur du câble entre le calculateur et le premier équipement relais.

Avantageusement, ce procédé d'identification est le plus indépendant possible de la variabilité des composants électroniques du calculateur.

A cet effet, l'invention a pour objet un procédé d'identification de l'existence d'une panne d'un équipement relais dans un système d'alimentation électrique d'un dispositif à alimenter, ledit système d'alimentation comportant au moins un générateur de puissance apte à générer un signal d'alimentation et une charge connectée à une sortie du générateur de puissance, ladite charge comportant au moins un équipement relais ; ledit générateur de puissance comportant un variateur de fréquence ; ledit équipement relais comprenant au moins un quadripôle passif et au moins une antenne reliée audit au moins un quadripôle passif ; caractérisé en ce que ledit procédé d'identification comprend les étapes suivantes :
a) sélectionner une fréquence caractéristique,
b) déterminer l'impédance de la charge en sortie du générateur de puissance, lorsque le signal d'alimentation présente la fréquence caractéristique sélectionnée,
c) répéter les étapes a) et b) pour plusieurs fréquences caractéristiques distinctes les unes des autres,
d) identifier l'existence d'une panne à partir de plusieurs impédances déterminées pour différentes fréquences caractéristiques.

L'invention a également pour objet un procédé d'identification d'un équipement relais en panne dans un système d'alimentation électrique d'un dispositif à alimenter, ledit système d'alimentation comportant au moins un générateur de puissance apte à générer un signal d'alimentation et une charge connectée à une sortie du générateur de puissance, ladite charge comportant au moins deux équipements relais ; ledit générateur de puissance comportant un variateur de fréquence ; chaque équipement relais comprenant au moins un quadripôle passif et au moins une antenne reliée audit au moins un quadripôle passif ; caractérisé en ce que ledit procédé d'identification comprend les étapes suivantes :
a) sélectionner une fréquence caractéristique,
b) déterminer l'impédance de la charge en sortie du générateur de puissance, lorsque le signal d'alimentation présente la fréquence caractéristique sélectionnée,
c) répéter les étapes a) et b) pour plusieurs fréquences caractéristiques distinctes les unes des autres,
d) identifier l'équipement relais en panne à partir de plusieurs impédances déterminées pour différentes fréquences caractéristiques.

De plus, l'invention a également pour objet un procédé d'identification du type de panne d'un équipement relais dans un système d'alimentation électrique d'un dispositif à alimenter, ledit système d'alimentation comportant au moins un générateur de puissance apte à générer un signal d'alimentation et une charge connectée à une sortie du générateur de puissance ladite charge comportant au moins un équipements relais ; ledit générateur de puissance comportant un variateur de fréquence; ledit équipement relais comprenant au moins un quadripôle passif et au moins une antenne reliée audit au moins un quadripôle passif ; caractérisé en ce que ledit procédé d'identification comprend les étapes suivantes:
a) sélectionner une fréquence caractéristique,
b) déterminer l'impédance de la charge en sortie du générateur de puissance, lorsque le signal d'alimentation présente la fréquence caractéristique sélectionnée,
c) répéter les étapes a) et b) pour plusieurs fréquences caractéristiques distinctes les unes des autres,
d) identifier le type de panne de l'équipement relais à partir de plusieurs impédances déterminées pour différentes fréquences caractéristiques.

Avantageusement, ce procédé exploite le fait que, l'impédance de la charge varie en fonction de la fréquence d'une manière déterminable en fonction du type de circuit implémenté dans chaque équipement. Ainsi, ce procédé permet avantageusement de s'affranchir des variations d'impédance liées aux caractéristiques du câble reliant le calculateur au premier équipement relais.

Selon l'invention, dans ces trois procédés, l'étape d'identification comprend une étape de comparaison de l'impédance déterminée à une fréquence caractéristique donnée à au moins un seuil, ledit au moins un seuil étant propre à ladite fréquence caractéristique donnée.

Suivant des modes particuliers de réalisation, ces trois procédés comportent l'une ou plusieurs des caractéristiques suivantes :
- le procédé comprend en outre les étapes suivantes :
   e) calculer la différence entre l'impédance déterminée à une fréquence caractéristique donnée et l'impédance déterminée à une autre fréquence caractéristique donnée,
   f) comparer ladite différence à au moins un seuil absolu, ledit au moins un seuil absolu étant spécifique à un couple comprenant ladite fréquence caractéristique donnée et ladite autre fréquence caractéristique donnée,
   g) répéter les étapes e) et f) pour plusieurs impédances déterminées.

   Avantageusement, la détermination de la variation d'impédance permet de s'affranchir encore davantage des caractéristiques et de la longueur du câble.
- l'étape d'identification comprend les étapes suivantes :
   h) calculer le quotient entre, d'une part, la différence entre l'impédance déterminée à une fréquence caractéristique donnée et l'impédance déterminée à une autre fréquence caractéristique donnée, et d'autre part une impédance parmi l'impédance déterminée à la fréquence caractéristique donnée et l'impédance déterminée à ladite autre fréquence caractéristique donnée,
   i) comparer ledit résultat de l'étape de calcul h) à au moins un seuil relatif, ledit seuil relatif, étant propre à chaque couple comprenant ladite fréquence caractéristique donnée et ladite autre fréquence caractéristique donnée, et
   j) répéter les étapes h) et i) pour plusieurs impédances déterminées.

   Avantageusement, cette étape permet de s'affranchir de la tolérance des composants de la chaine de mesure du calculateur.
- le procédé comporte en outre les étapes suivantes :
   j) attribuer le résultat de chaque comparaison dans une catégorie parmi des catégories de référence,
   k) comparer les catégories attribuées au cours de l'étape j) à des catégories de référence.
- le système d'alimentation comporte une charge de référence connectée à la sortie du générateur de puissance en série aux équipements relais, ladite charge de référence ayant une impédance connue à au moins une fréquence caractéristique et dans lequel l'étape de détermination de l'impédance de la charge comprend les étapes suivantes :
   - déterminer la tension à la sortie du générateur de puissance,
   - déterminer la tension aux bornes de la charge,
   - calculer la différence entre la tension déterminée à la sortie du générateur de puissance et la tension déterminée aux bornes de la charge et déterminer l'impédance de la charge à partir de ladite différence et de l'impédance de la charge de référence.
- lesdites fréquences caractéristiques sont déterminées en fonction d'au moins un élément parmi le type de circuit de chaque équipement relais, les caractéristiques du au moins un quadripôle passif et les caractéristiques de l'antenne.

En outre, l'invention a pour objet un programme informatique, caractérisé en ce qu'il comporte des instructions pour mettre en œuvre le procédé d'identification selon l'une quelconque des caractéristiques mentionnées ci-dessus, lorsqu'elles sont exécutées par un calculateur.

Enfin, l'invention a pour objet un système d'alimentation électrique d'un dispositif à alimenter ; ledit système d'alimentation comportant :
- au moins un générateur de puissance apte à générer un signal d'alimentation ;
- une charge comportant au moins un équipement relais ; ledit au moins un équipement relais comprenant au moins quadripôle passif et au moins une antenne reliée audit au moins un quadripôle passif ;
caractérisé en ce que le système d'alimentation comporte un calculateur et en ce que ledit générateur de puissance comporte un variateur de fréquence commandé par ledit calculateur; ledit calculateur étant propre à mettre en œuvre le procédé d'identification selon l'une quelconque des caractéristiques mentionnées ci-dessus.

En variante, une charge de référence ayant une impédance connue à au moins une fréquence caractéristique est connectée à la sortie du générateur de puissance en série avec ledit au moins un équipement relais.

L'invention sera mieux comprise à la lecture de la description qui va suivre, donnée uniquement à titre d'exemple et faite en se référant aux figures sur lesquelles :
- la figure 1 est une vue schématique d'un circuit d'alimentation d'un dispositif à alimenter selon l'invention,
- la figure 2 est un graphe représentant des exemples de variations de la tension de la charge en fonction de la fréquence dans le circuit d'alimentation représenté sur la figure 1, lorsque les deux équipements relais sont dans un état de fonctionnement,
- les figures 3 à 5 sont des graphes similaires au graphe représenté sur la figure 2 lorsque l'un ou l'autre des équipements relais présente un exemple de cas typique de panne,
- les figures 6 et 7 sont des diagrammes représentant les étapes du procédé d'identification selon la présente invention.

Le circuit d'alimentation 2 selon la présente invention sera décrit dans le cadre d'un exemple d'utilisation dans lequel il comporte deux équipements relais. Mais cet exemple d'utilisation n'est nullement limitatif, l'invention pouvant être appliquée dans tout système d'alimentation comportant au moins un équipement relais.

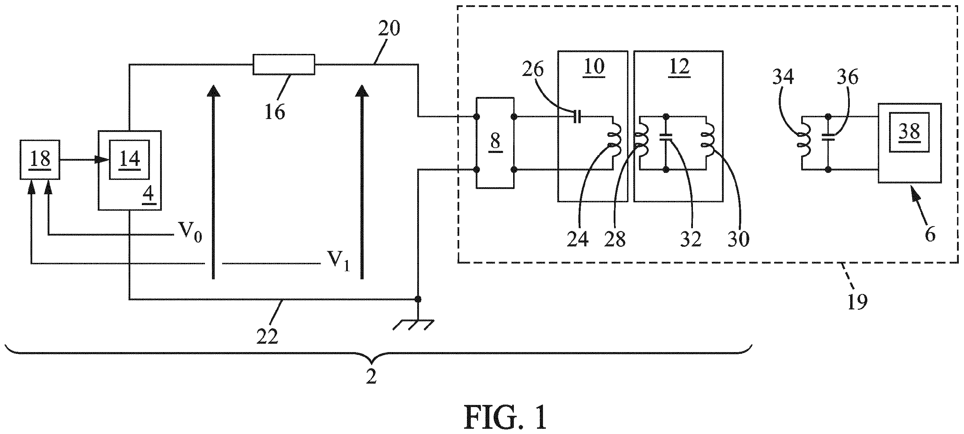

En référence à la figure 1, le circuit d'alimentation 2 selon cet exemple de réalisation comporte un générateur de puissance 4 propre à générer un signal d'alimentation apte à alimenter un dispositif à alimenter 6, par l'intermédiaire d'un câble 8, d'un premier 10 et d'un deuxième 12 équipements relais.

Le circuit d'alimentation 2 selon la présente invention peut, par exemple, être utilisé pour alimenter un capteur de pression 6 monté sur une roue d'un avion. Dans cet exemple d'utilisation, le dispositif à alimenter 6 est donc constitué par le capteur de pression. Le premier équipement relais 10 est fixé à l'essieu portant la roue de l'avion. Il est connecté par le câble 8 au générateur de puissance 4. Le deuxième équipement relais 12 est fixé sur la roue au droit du capteur de pression.

L'utilisation de ces deux équipements relais 10, 12 permet avantageusement de passer de la partie fixe, c'est-à-dire du premier équipement relais 10 fixé sur l'essieu, à la partie mobile, c'est-à-dire au deuxième équipement relais 12 fixé sur la roue. L'utilisation de ces deux équipements relais 10, 12 permet également de démonter facilement le capteur de pression 6 en évitant une liaison filaire entre le deuxième équipement relais 12 et le capteur de pression 6.

Le générateur de puissance 4 comporte un variateur de fréquence 14 qui est adapté pour faire varier la fréquence du signal d'alimentation dans une plage donnée autour d'une fréquence centrale. Le signal d'alimentation est un signal basse fréquence. Il présente par exemple, une fréquence de 125 kHz. Il est par exemple propre à varier dans une plage comprise entre 75 kHz et 175 kHz. Selon le mode de réalisation décrit, le signal d'alimentation est formé d'une porteuse modulée en amplitude, la modulation en amplitude permettant de transmettre des données telles que, par exemple, des commandes au capteur de pression 6.

Le circuit d'alimentation 2 comporte, en outre, une charge de référence 16 connectée en sortie du générateur de puissance 4 et un calculateur 18 propre à mesurer la tension de sortie V₀ du générateur de puissance 4, ainsi que la tension V₁ d'une charge 19 connectée en série à la charge de référence 16.

En général, dans un avion la puissance électrique provient d'un générateur de puissance central et le calculateur 18 comporte des convertisseurs de puissance propres à convertir la tension et la fréquence du signal d'alimentation.

Dans la présente description, le terme « charge 19 » désigne la charge constituée par le câble 8, le premier équipement relais 10, le deuxième équipement relais 12 et le capteur de pression 6. De même, le terme « impédance de la charge 19 » désigne l'impédance de l'ensemble constitué par le câble 8, le premier équipement relais 10, le deuxième équipement relais 12 et le capteur de pression 6.

La charge de référence 16 présente une impédance précise. Selon le mode de réalisation décrit pour l'exemple, la charge de référence 16 est une résistance.

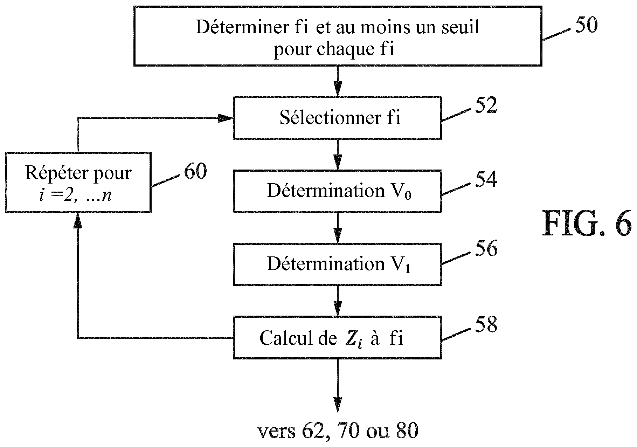

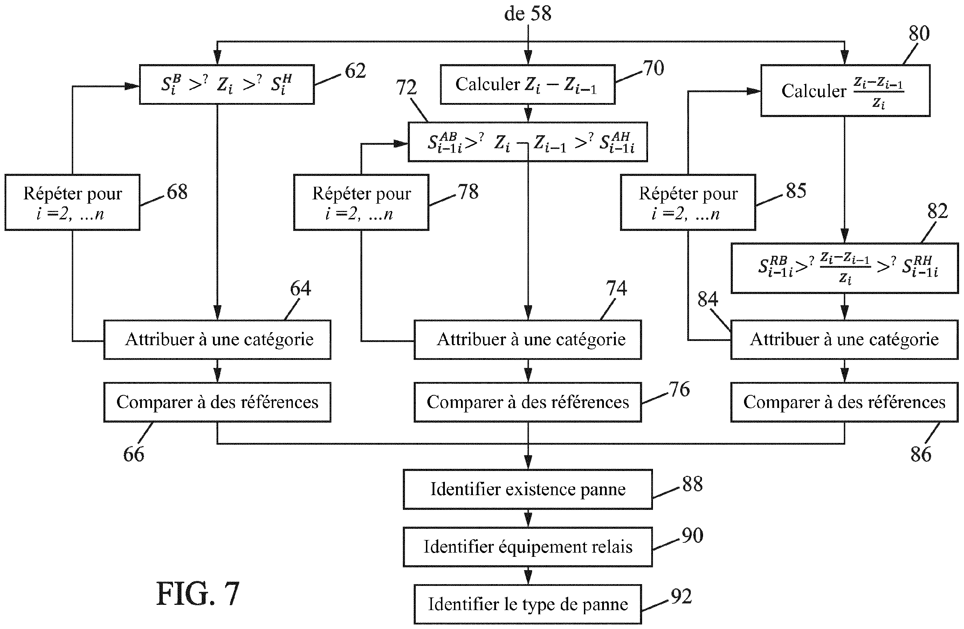

Le calculateur 18 comprend une mémoire contenant la valeur de l'impédance de la charge de référence 16. Le calculateur 18 est apte à commander le variateur de fréquence 14. Il est adapté pour démoduler l'amplitude du courant transmis par le capteur de pression 6 pour réceptionner les informations de mesure de pression ou toute information transmise par le capteur 6. Le calculateur 18 est apte à exécuter les procédés d'identification selon la présente invention illustrés sur les figures 6 et 7 et décrits ci-après.

Le câble 8 est constitué d'un premier brin 20 et d'un second brin 22. La charge de référence 16 est montée sur le premier brin entre une borne du générateur de puissance 4 et le premier équipement relais 10. Le second brin 22 constitue la ligne de retour de courant. Il est relié au générateur de puissance 4 et au premier équipement relais 10. Le câble 8 comporte des inductances et des capacités de filtrage en sortie du calculateur non représentées pour filtrer les perturbations électromagnétiques conformément aux exigences de compatibilité électromagnétiques CEM.

Le premier équipement relais 10 et le deuxième équipement relais 12 sont des équipements relais ne comportant que des éléments passifs (résistances, capacités, inductances) c'est-à-dire des équipements relais ne comportant pas de système d'alimentation en énergie électrique embarqué.

Le premier équipement relais 10, monté sur l'essieu, comporte une antenne 24 et une capacité d'accord 26 connectée selon un montage en série à ladite antenne 24. Cette connexion série permet de maximiser le courant transmis et ainsi le champ magnétique généré par l'antenne 24.

Le deuxième équipement relais 12, monté sur la roue, comporte une première antenne 28 placée en face de l'antenne 24 du premier équipement relais 10, une deuxième antenne 30 placée en face du capteur de pression 6 et une capacité d'accord 32 connectée selon un montage en parallèle à la première 28 et à la deuxième 30 antennes. Le montage en parallèle des antennes et de la capacité d'accord permet d'augmenter le niveau de tension du système d'alimentation par une résonance parallèle.

Le capteur de pression 6, fixé à la roue, comporte une antenne 34 placée en face de la deuxième antenne 30 du deuxième équipement relais, une capacité d'accord 36 connectée selon un montage en parallèle à l'antenne 34, un calculateur 38 ainsi que des éléments non représentés permettant de mesurer la pression du pneu.

L'antenne 34 est propre à réceptionner le champ magnétique du signal d'alimentation et à générer un courant d'alimentation alimentant les composants électroniques du capteur de pression. L'antenne 34 est également apte à renvoyer les informations de mesure de pression au calculateur 18, par exemple, par modulation de charge, de tension ou de courant de son entrée.

De façon connue en soi, le calculateur 38 est apte à démoduler le signal d'alimentation pour récupérer les consignes données par le calculateur 16. Le calculateur 38 commande des composants pour générer et transmettre les informations de mesure de pression.

En variante, le système d'alimentation fonctionne en mode différentiel. Dans ce cas, le générateur de puissance 4 est remplacé par deux générateurs : un premier générateur étant connecté entre le premier brin 20 et la masse, le second générateur étant connecté entre le second brin 22 et la masse. Le signal d'alimentation émis par le second générateur présente la même fréquence et est déphasé de 180 ° par rapport au signal d'alimentation généré par le premier générateur de puissance. L'impédance de la charge de référence 16 est alors répartie équitablement sur le premier brin 20 et le second brin 22. Cette variante permet avantageusement de se prémunir de toute perturbation extérieure de type mode commun, telle que par exemple des fluctuations de masse entre équipement ou des perturbations CEM.

En variante, le signal d'alimentation peut être un signal en moyenne ou en haute fréquence.

En variante, le signal d'alimentation n'est pas modulé en amplitude. Cette variante étant utilisée lorsqu'il n'est pas nécessaire de communiquer avec le capteur de pression 6 ou lorsque la communication est réalisée par d'autres moyens de communication.

En variante, le capteur de pression 6 est remplacé par un capteur de température, d'effort, de déformation ou un capteur d'un actionneur (liste non exhaustive), ou par plusieurs capteurs de ce type. L'ensemble de ces capteurs visant à contrôler et à surveiller le fonctionnement et le vieillissement des équipements déportés.

De manière plus générale,
- Le signal généré par le calculateur de puissance 4 peut être remplacé par un générateur de courant.
- Les capacités d'accord 26, 32, 36 sont des quadripôles passifs Elles peuvent être remplacées par d'autres quadripôles passifs à base de capacités, résistances et/ou inductances ou être remplacés par des montages sans capacités. Par exemple, selon une variante de la présente invention, la capacité d'accord 32 du deuxième équipement relais est remplacée par un filtre en Pi (triangle), ou un filtre en LC, la capacité d'accord 36 du dispositif à alimenter est remplacée par une capacité série ou un filtre en L et le premier équipement relais 10 ne comporte pas de capacité d'accord 26.
- Le premier équipement relais 10 et le deuxième équipement relais 12 sont remplacés par un unique équipement relais.
- Un câble de liaison peut remplacer la deuxième antenne 30 et l'antenne 34 du dispositif à alimenter.
- Les mesures de tension V0 et V1 pourraient être remplacées ou complétées par des mesures de courant de sortie dans la charge de référence 16.

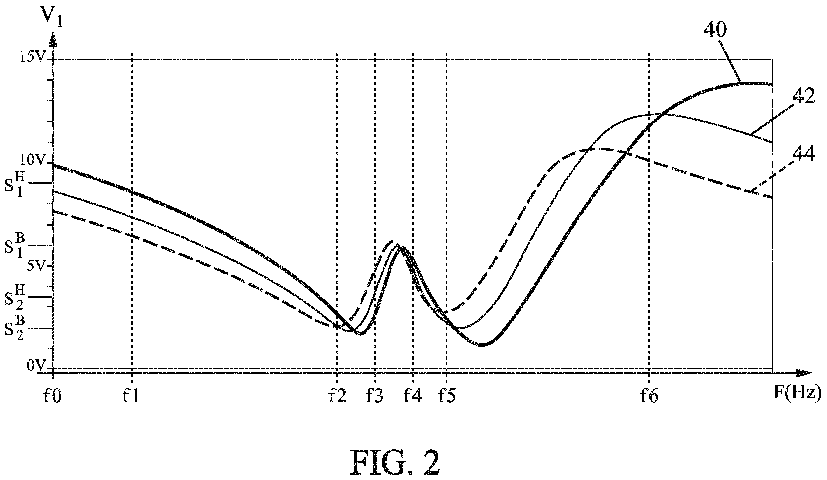

Le principe de l'invention se base sur le fait que l'impédance de la charge 19 varie en fonction de la fréquence selon des courbes caractéristiques des montages de quadripôle passif. En particulier, dans l'exemple de l'invention illustré sur les figures l'impédance de la charge 19 varie en fonction de la fréquence selon des courbes caractéristiques des phénomènes de résonnance des montages en série ou en parallèle des circuits comprenant une antenne et une capacité d'accord. En effet, en référence à la figure 2, les courbes 40, 42, 44 représentent les variations de la tension aux bornes de la charge 19 en fonction de la fréquence du signal d'alimentation. Ces courbes 40, 42, 44 présentent entre les fréquences f1 et f6, une forme en V caractéristique de la résonance série entre la capacité d'accord 26 et l'antenne 24 et, entre les fréquences f2 et f5, une forme en pic de résonance caractéristique de la résonance parallèle entre la première antenne 28, la deuxième antenne 30 et la capacité d'accord 32.

La courbe en trait fort 40 représente la variation de la tension de la charge 19 lorsque le câble 8 présente une longueur de 1 mètre. La courbe en trait fin 42 représente la variation de la tension de la charge 19, lorsque le câble 8 présente une longueur de 31 mètres. Et enfin, la courbe en traits pointillés 44 représente la variation de la tension de la charge 19, lorsque le câble 8 présente une longueur de 61 mètres.

Comme visible sur la figure 2, l'évolution de ces courbes est très peu dépendante de la longueur du câble 8. Il est possible de définir des périodes de croissance et de décroissance entre des fréquences données. Ces fréquences sont caractéristiques du type de montage en parallèle ou en série ainsi que des caractéristiques des capacités d'accord et des caractéristiques des antennes. Elles sont appelées ci-après fréquences caractéristiques fi. Ainsi, la détermination de l'impédance de la charge 19 à différentes fréquences caractéristiques des équipements relais permet de mener une analyse très peu dépendante des caractéristiques des câbles de liaison.

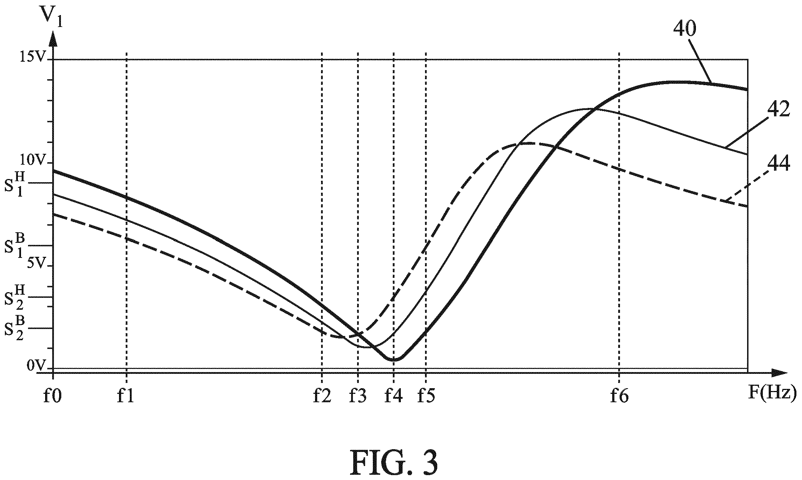

En référence à la figure 3, les courbes 40, 42, 44 représentent les variations de tension de la charge 19 en fonction de la fréquence du signal d'alimentation, lorsque l'antenne 28 du deuxième équipement relais est en circuit ouvert. La forme en pic de résonance caractéristique de la résonance en parallèle du deuxième équipement relais 12 n'est pas visible sur cette figure. En conséquence, il est possible d'en déduire que le deuxième équipement relais 12 est en panne.

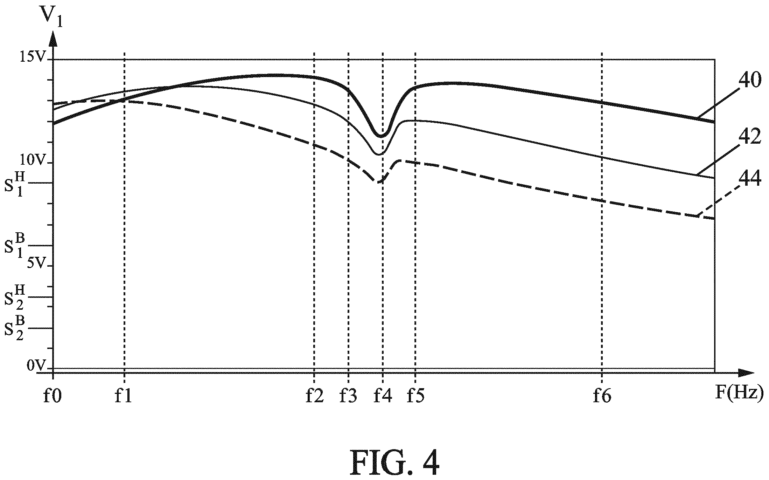

La figure 4 représente les mêmes courbes de mesure de variations de tension en fonction de la fréquence, lorsque la capacité d'accord 26 est en court-circuit. Dans ce cas, la forme en V caractéristique d'une résonance série n'est plus présente.

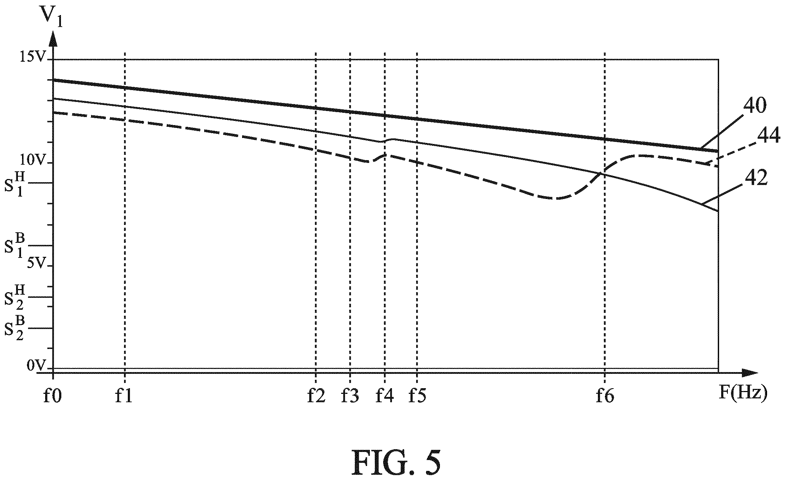

Enfin, la figure 5 est similaire aux figures 2 à 4. Elle représente les variations de tension de la charge 19 en fonction de la fréquence du signal d'alimentation, lorsqu'un brin de câble du premier équipement relais 10 est déconnecté.

Par ailleurs, l'impédance de la charge varie également en fonction des caractéristiques des capacités d'accord et des caractéristiques des antennes utilisées dans chaque circuit. Par exemple, la fréquence de résonance centrale ou la largeur du motif sont modifiées, lorsque les caractéristiques des capacités d'accord et des antennes sont modifiées. Du fait de la tolérance des composants choisis ou de l'ajout d'une procédure d'appariement entre les composants (en anglais de « tuning »), ce paramètre reste secondaire par rapport aux autres variables du système et notamment de la longueur de câbles et des tolérances des composants utilisés dans le générateur de puissance 4.

Le choix de fréquences caractéristiques de la nature de la charge 19 permet d'obtenir des informations caractéristiques de cette charge 19, et notamment de la présence ou non des équipements relais 10, 12. L'analyse des valeurs d'impédance mesurées aux fréquences caractéristiques permet d'identifier l'équipement relais en défaut.

En référence aux figures 6 et 7, les procédés d'identification selon l'invention vont à présent être décrits.

Au cours d'une étape préalable d'analyse 50, réalisée au cours du développement des produits, des fréquences, dites fréquences caractéristiques fi sont déterminées par un opérateur. Ces fréquences caractéristiques fi sont choisies en fonction de l'évolution de la courbe de variation de la tension de la charge 19 en fonction de la fréquence, dans différentes situations à savoir lorsque aucun équipement relais n'est en panne ou dans les cas les plus typiques de panne tels que les circuits ouverts ou les courts-circuits sur chacun des équipements relais. Une fois choisies, ces fréquences caractéristiques sont figées dans le logiciel du calculateur 18.

Par exemple, dans le mode de réalisation illustré sur les figures 2 à 5, les fréquences caractéristiques f1, f2, f3, f4, f5, f6 ont été choisies. Pour chacune de ces fréquences caractéristiques un ou plusieurs seuils ont été déterminés. Ces seuils sont différents selon la méthode d'identification qui sera utilisée comme décrit ci-après. Sans s'y restreindre, deux seuils ont été pris dans l'exemple décrit.

Au cours d'une étape 52, le calculateur 18 commande le variateur de fréquence 14 afin que celui-ci sélectionne une première fréquence caractéristique fi par exemple la fréquence caractéristique f1.

Au cours d'une étape 54, le calculateur 18 détermine la tension V₀ aux bornes de sortie du générateur de puissance 4, lorsque la fréquence du signal d'alimentation est la fréquence caractéristique f1.

Au cours d'une étape 56, le calculateur 18 détermine la tension V₁ aux bornes de la charge 19, lorsque la fréquence du signal d'alimentation est la fréquence caractéristique f1.

Au cours d'une étape 58, le calculateur 18 calcule l'impédance Z₁ de la charge 19, lorsque la fréquence du signal d'alimentation est la fréquence caractéristique f1. Cette impédance Z₁ est calculée en utilisant la loi d'Ohm et le principe d'un montage en pont diviseur à partir du rapport entre la tension V₀ et la tension V₁, et de la valeur de l'impédance de la charge de référence 16 stockée dans le calculateur 18. L'impédance de la charge de référence 16 étant connue et fixe, le calcul de l'impédance Zᵢ peut se réduire éventuellement au simple calcul de la différence de tension V₀-Vᵢ, grandeur équivalente à Zᵢ à un facteur de normalisation prés, donc présentant les mêmes variations en fréquence que Zᵢ.

Au cours d'une étape 60, les étapes 52 à 58 sont répétées pour l'ensemble des fréquences caractéristiques fi déterminées au cours de l'étape 50, par exemple pour les fréquences caractéristiques f2 à f6. Notez que le nombre de fréquences n=6 est arbitraire et peut être différent de celui décrit dans le présent exemple.

Le procédé d'identification selon l'invention comporte ensuite trois méthodes permettant toutes les trois de détecter l'existence d'une panne, d'identifier l'équipement relais en panne et d'identifier le type de panne parmi les pannes les plus usuelles.

La première méthode est définie par l'ensemble des étapes 62 à 68. La deuxième méthode est définie par l'ensemble des étapes 70 à 78. La troisième méthode est définie par l'ensemble des étapes 80 à 90.

Les cas de panne les plus différents d'un fonctionnement normal peuvent être identifiés avec la première méthode et la deuxième méthode. La troisième méthode qui teste les variations en valeurs relatives, permet d'affiner l'analyse à des variations d'impédances moins marquées entre les différents cas de panne et le fonctionnement normal. L'intérêt de la troisième méthode est de s'affranchir de la tolérance des composants électroniques utilisés dans le générateur de puissance 4. Elles s'appliquent dès que l'identification de la panne d'un équipement relais peut se faire par une mesure d'impédance relative, ce qui n'est pas toujours le cas. De manière générale, les trois méthodes peuvent être complémentaires pour mener à bien une analyse complète de tous les cas de panne des équipements relais.

Nous allons décrire chacune de ces trois méthodes, étant entendu que l'invention peut être mise en œuvre en utilisant une seule et une quelconque de ces méthodes ou une combinaison de deux quelconques de ces méthodes ou une combinaison de ces trois méthodes.

La première méthode comprend les étapes 62 à 68.

Au cours de l'étape 62, l'impédance Z₁ déterminée pour la fréquence caractéristique f1 est comparée à au moins un seuil. Dans l'exemple illustré, l'impédance Z₁ est comparée à un seuil bas S₁^{B} et à un seuil haut S₁^{H} définis pour cette fréquence caractéristique f1. Le seuil bas S₁^{B} et le seuil haut S₁^{H} délimitent une plage de variation d'impédance. Le seuil bas S₁^{B} et le seuil haut S₁^{H} sont déterminés au cours de l'étape d'analyse 50 en tenant compte de l'évolution des courbes 40, 42 et 44 dans les états de fonctionnement ou de non fonctionnement de chaque équipement relais. Un exemple de seuil bas et de seuil haut définis pour les fréquences caractéristiques f1 et f2 a été illustré sur la figure 2.

Au cours d'une étape 64, le calculateur 18 attribue le résultat de la comparaison réalisée au cours de l'étape 62 à une catégorie parmi les trois catégories suivantes :
- Première catégorie : l'impédance Z₁ est inférieure au seuil bas S₁^{B} et au seuil haut S₁^{H},
- Deuxième catégorie : l'impédance Z₁ est supérieure au seuil bas S₁^{B} et inférieure au seuil haut S₁^{H},
- Troisième catégorie : l'impédance Z₁ est supérieure au seuil bas S₁^{B} et au seuil haut S₁^{H}.

Les étapes 62 et 64 sont ensuite répétées pour l'ensemble des impédances Zᵢ définies pour les fréquences caractéristiques fᵢ, au cours d'une étape 68, par exemple pour les fréquences f2 à f6.

Au cours d'une étape 66, le calculateur 18 compare les catégories attribuées à des catégories de référence contenues un tableau de référence.

En variante, à la fin de l'étape 64, le calculateur 18 génère un code logique en fonction du résultat de la comparaison. Puis, au cours de l'étape 66, le calculateur 18 compare les codes logiques générés aux étapes 64 pour chaque fréquence à des catégories de référence dans un tableau de référence. Le calculateur peut éventuellement concaténer les différents codes logiques générés aux étapes 64 pour chaque fréquence.

La deuxième méthode comprend les étapes 70 à 78.

Au cours de l'étape 70, le calculateur 18 calcule la différence entre deux impédances déterminées au cours de l'étape 58. De préférence, cette différence est calculée pour des impédances déterminées à des fréquences successives. Par exemple, la différence Z₂ - Z₁ est calculée.

Au cours d'une étape 72, cette différence Z₂ - Z₁ est comparée à au moins en seuil absolu. Dans cet exemple de réalisation, cette différence est comparée à un seuil absolu bas S₁₂^{AB} et à un seuil absolu haut S₁₂^{AH} définis pour le couple de fréquences caractéristiques f1, f2.

Au cours d'une étape 74, le calculateur 18 attribue le résultat de la comparaison réalisée au cours de l'étape 72 à une catégorie parmi les trois catégories suivantes :
- Première catégorie : la différence d'impédance Z₂ - Z₁ est inférieure au seuil absolu bas S₁₂^{AB} et au seuil absolu haut S₁₂^{AH},
- Deuxième catégorie : la différence d'impédance Z₂ - Z₁ est supérieure au seuil absolu bas S₁₂^{AB} et inférieure au seuil absolu haut S₁₂^{AH},
- Troisième catégorie : la différence d'impédance Z₂ - Z₁ est supérieure au seuil absolu bas S₁₂^{AB} et au seuil absolu haut S₁₂^{AH},

Les étapes 70 à 74 sont répétées pour les impédances Zᵢ définies pour les couples de fréquences caractéristiques fi, fi-1, au cours d'une étape 78.

Au cours d'une étape 76, le calculateur 18 compare les différentes catégories attribuées au cours de l'étape 74 à des catégories de référence dans un tableau de référence.

En variante, à la fin de l'étape 74, le calculateur 18 génère un code logique en fonction du résultat de la comparaison. Puis, au cours de l'étape 76, le calculateur 18 compare les codes logiques générés aux étapes 74 pour chaque fréquence à des catégories de référence dans un tableau de référence. Le calculateur peut éventuellement concaténer les différents codes logiques générés aux étapes 64 pour chaque fréquence.

La troisième méthode comprend les étapes 80 à 86.

L'étape 80 est similaire à l'étape 70 à l'exception du fait que la valeur relative des différences entre les impédances est déterminée. La mise en œuvre de cette troisième méthode permet de s'affranchir de la tolérance des composants électroniques dans la chaine de mesure et dans la chaine du générateur de tension du calculateur 18. Cela permet d'éliminer le gain hardware de la fonction du calculateur et de rendre les valeurs testées plus robuste aux variations des valeurs des composants électroniques.

Ainsi, au cours de l'étape 80, la différence entre les deux impédances Zᵢ - Zᵢ₋₁ est divisée par l'impédance Zᵢ ou par l'impédance Zᵢ₋₁. Par exemple, le quotient est calculé.

Au cours d'une étape 82, le quotient est comparé à au moins un seuil relatif. Dans l'exemple illustré, le quotient est comparé à un seuil relatif bas S₁₂^{RB} et à un seuil relatif haut S₁₂^{RH} définis pour le couple de fréquences caractéristiques f1, f2.

Au cours d'une étape 84, le calculateur 18 attribue le résultat de la comparaison réalisée au cours de l'étape 82 à une catégorie parmi les trois catégories suivantes :
- Première catégorie : le quotient est inférieur au seuil relatif bas S₁₂^{RB} et au seuil relatif haut S₁₂^{RH},
- Deuxième catégorie : le quotient est supérieur au seuil relatif bas S₁₂^{RB} et inférieure au seuil relatif haut S₁₂^{RH},
- Troisième catégorie : le quotient est supérieur au seuil relatif bas S₁₂^{RB} et au seuil relatif haut S₁₂^{RH}.

Au cours d'une étape 85, les étapes 80 et 82 sont répétées pour les impédances Zᵢ définies pour les couples de fréquences caractéristiques fi, fi-1.

Au cours d'une étape 86, le calculateur 18 compare les catégories attribuées au cours des étapes 84 à des catégories de référence.

Au cours d'une étape 88, le calculateur 18 identifie si un équipement relais est en panne à partir du résultat des comparaisons effectuées au cours de la première méthode et/ou de la deuxième méthode et/ou de la troisième méthode.

Au cours d'une étape 90, le calculateur 18 identifie quel est l'équipement relais en panne, c'est-à-dire il détermine si c'est le premier équipement relais 10 qui est en panne ou si c'est le deuxième équipement relais 12 qui est en panne à partir du résultat des comparaisons effectuées au cours de la première méthode et/ou de la deuxième méthode et/ou de la troisième méthode.

Au cours d'une étape 92, le calculateur 18 identifie en outre quel est le type de panne de l'équipement relais identifié au cours de l'étape 72 également à partir du résultat des comparaisons effectuées au cours de la première méthode et/ou de la deuxième méthode et/ou de la troisième méthode.

Généralement, la détection du type de panne nécessite la détermination d'un plus grand nombre de fréquences caractéristiques fi ou une analyse plus fine des résultats.

L'invention peut être utilisée pour identifier l'équipement relais en panne ou pour identifier le type de panne sans être utilisée pour identifier l'existence de la panne.

L'invention pourrait également être utilisée pour identifier une panne ou le type de panne sur le dispositif à alimenter. Dans ce cas, le terme équipement relais utilisé dans cette demande peut également comprendre le dispositif à alimenter dans la mesure où celui-ci comporte une antenne et une capacité d'accord.

## Revendications

1. Procédé d'identification de l'existence d'une panne d'un équipement relais dans un système d'alimentation électrique (2) d'un dispositif à alimenter (6), ledit système d'alimentation (2) comportant au moins un générateur de puissance (4) apte à générer un signal d'alimentation et une charge (19) connectée à une sortie du générateur de puissance (4), ladite charge (19) comportant au moins un équipement relais (10, 12) ; ledit générateur de puissance (4) comportant un variateur de fréquence (14) ; ledit équipement relais (10, 12) comprenant au moins un quadripôle passif (26, 32, 36) et au moins une antenne (24, 28, 30) reliée audit au moins un quadripôle passif (26, 32, 36) ; **caractérisé en ce que** ledit procédé d'identification comprend les étapes suivantes :
a) sélectionner (52) une fréquence caractéristique (fi, f1),
b) déterminer (54, 56, 58) l'impédance (Zᵢ) de la charge (19) en sortie du générateur de puissance (4), lorsque le signal d'alimentation présente la fréquence caractéristique (fi, f1) sélectionnée,
c) répéter (60) les étapes a) et b) pour plusieurs fréquences caractéristiques (fi, f1) distinctes les unes des autres,
d) identifier (88) l'existence d'une panne à partir de plusieurs impédances (Zᵢ) déterminées pour différentes fréquences caractéristiques (fi, f1),
l'étape d'identification (88) comprenant une étape de comparaison (62) de l'impédance (Zᵢ) déterminée à une fréquence caractéristique donnée (fi, f1) à au moins un seuil (S₁^{H,} Sᵢ^{H;} S₁^{B,} Sᵢ^{B}), ledit au moins un seuil (S₁^{H,} Sᵢ^{H}; S₁^{B,} Sᵢ^{B}) étant propre à ladite fréquence caractéristique donnée (fi, f1).

2. Procédé d'identification d'un équipement relais en panne dans un système d'alimentation électrique (2) d'un dispositif à alimenter (6), ledit système d'alimentation (2) comportant au moins un générateur de puissance (4) apte à générer un signal d'alimentation et une charge (19) connectée à une sortie du générateur de puissance, ladite charge (19) comportant au moins deux équipements relais (10, 12) ; ledit générateur de puissance (4) comportant un variateur de fréquence (14) ; chaque équipement relais (10, 12) comprenant au moins un quadripôle passif (26, 32, 36) et au moins une antenne (24, 28, 30) reliée audit au moins un quadripôle passif (26, 32, 36) ; **caractérisé en ce que** ledit procédé d'identification comprend les étapes suivantes :
a) sélectionner (52) une fréquence caractéristique (fi, f1),
b) déterminer (54, 56, 58) l'impédance (Zᵢ) de la charge (19) en sortie du générateur de puissance (4), lorsque le signal d'alimentation présente la fréquence caractéristique (fi, f1) sélectionnée,
c) répéter (60) les étapes a) et b) pour plusieurs fréquences caractéristiques (fi, f1) distinctes les unes des autres,
d) identifier (90) l'équipement relais (10, 12) en panne à partir de plusieurs impédances (Zᵢ) déterminées pour différentes fréquences caractéristiques (fi, f1),
l'étape d'identification (90) comprenant une étape de comparaison (62) de l'impédance (Zᵢ) déterminée à une fréquence caractéristique donnée (fi, f1) à au moins un seuil (S₁^{H,} Sᵢ^{H;} S₁^{B,} Sᵢ^{B}), ledit au moins un seuil (S₁^{H,} Sᵢ^{H}; S₁^{B,} Sᵢ^{B}) étant propre à ladite fréquence caractéristique donnée (fi, f1).

3. Procédé d'identification du type de panne d'un équipement relais dans un système d'alimentation électrique (2) d'un dispositif à alimenter (6), ledit système d'alimentation (2) comportant au moins un générateur de puissance (4) apte à générer un signal d'alimentation et une charge (19) connectée à une sortie du générateur de puissance (4) ladite charge (19) comportant au moins un équipement relais (10, 12) ; ledit générateur de puissance (4) comportant un variateur de fréquence (14) ; ledit équipement relais (10, 12) comprenant au moins un quadripôle passif (26, 32, 36) et au moins une antenne (24, 28, 30) reliée audit au moins un quadripôle passif (26, 32, 36); **caractérisé en ce que** ledit procédé d'identification comprend les étapes suivantes:
a) sélectionner (52) une fréquence caractéristique (fi, f1),
b) déterminer (54, 56, 58) l'impédance (Zᵢ) de la charge (19) en sortie du générateur de puissance (4), lorsque le signal d'alimentation présente la fréquence caractéristique (fi, f1) sélectionnée,
c) répéter (60) les étapes a) et b) pour plusieurs fréquences caractéristiques (fi, f1) distinctes les unes des autres,
d) identifier (92) le type de panne de l'équipement relais (10, 12) à partir de plusieurs impédances (Zᵢ) déterminées pour différentes fréquences caractéristiques (fi, f1),
l'étape d'identification (92) comprenant une étape de comparaison (62) de l'impédance (Zᵢ) déterminée à une fréquence caractéristique donnée (fi, f1) à au moins un seuil (S₁^{H,} Sᵢ^{H;} S₁^{B,} Sᵢ^{B}), ledit au moins un seuil (S₁^{H,} Sᵢ^{H}; S₁^{B,} Sᵢ^{B}) étant propre à ladite fréquence caractéristique donnée (fi, f1).

4. Procédé d'identification selon l'une quelconque des revendications 1 à 3, qui comprend en outre les étapes suivantes :
e) calculer (70) la différence entre l'impédance (Zᵢ) déterminée à une fréquence caractéristique donnée (fi, f1) et l'impédance (Zᵢ₋₁) déterminée à une autre fréquence caractéristique donnée (fi-1, f1),
f) comparer (72) ladite différence à au moins un seuil absolu (S₁^{AH}, Sᵢ^{AH;} S₁^{AB}, Sᵢ^{AB}), ledit au moins un seuil absolu (S₁^{AH}, Sᵢ^{AH} ; S₁^{AB}, Sᵢ^{AB}) étant spécifique à un couple comprenant ladite fréquence caractéristique donnée (fi, f1) et ladite autre fréquence caractéristique donnée (fi-1, f1),
g) répéter (78) les étapes e) et f) pour plusieurs impédances (Zᵢ) déterminées.

5. Procédé d'identification selon l'une quelconque des revendications 1 à 4, dans lequel l'étape d'identification comprend les étapes suivantes :
h) calculer (80) le quotient entre, d'une part, la différence entre l'impédance déterminée (Zᵢ) à une fréquence caractéristique donnée (fi, f1) et l'impédance (Zᵢ₋₁) déterminée à une autre fréquence caractéristique donnée (fi-1, f1), et d'autre part une impédance parmi l'impédance déterminée (Zᵢ) à la fréquence caractéristique donnée et l'impédance déterminée (Zᵢ₋₁) à ladite autre fréquence caractéristique donnée,
i) comparer (82) ledit résultat de l'étape de calcul h) à au moins un seuil relatif (S₁^{RH}, Sᵢ^{RH}; S₁^{RB}, Sᵢ^{RB}), ledit seuil relatif (S₁^{RH}, Sᵢ^{RH} ; S₁^{RB}, Sᵢ^{RB}), étant propre à chaque couple comprenant ladite fréquence caractéristique donnée (fi, f1) et ladite autre fréquence caractéristique donnée (fi-1, f1), et
j) répéter (85) les étapes h) et i) pour plusieurs impédances (Zᵢ) déterminées.

6. Procédé d'identification selon la revendication 4 ou 5, qui comporte en outre les étapes suivantes :
j) attribuer (64, 74, 84) le résultat de chaque comparaison dans une catégorie parmi des catégories de référence
k) comparer (66, 76, 86) les catégories attribuées au cours de l'étape j) à des catégories de référence.

7. Procédé d'identification selon l'une quelconque des revendications 1 à 6, dans lequel le système d'alimentation (2) comporte une charge de référence (16) connectée à la sortie du générateur de puissance (4) en série aux équipements relais (10, 12), ladite charge de référence (16) ayant une impédance connue à au moins une fréquence caractéristique (fi, f1), et dans lequel l'étape de détermination (54, 56, 58) de l'impédance (Zᵢ) de la charge (19) comprend les étapes suivantes :
- déterminer (54) la tension (V₀) à la sortie du générateur de puissance (4),
- déterminer (56) la tension (V₁) aux bornes de la charge (19),
- calculer (58) la différence entre la tension (V₀) déterminée à la sortie du générateur de puissance (4) et la tension (V₁) déterminée aux bornes de la charge (19) et déterminer l'impédance de la charge (19) à partir de ladite différence et de l'impédance de la charge de référence (16).

8. Procédé d'identification selon l'une quelconque des revendications 1 à 7, dans lequel lesdites fréquences caractéristiques (fᵢ, f₁, f₂) sont déterminées en fonction d'au moins un élément parmi le type de circuit de chaque équipement relais (10, 12), les caractéristiques du au moins un quadripôle passif (26, 32, 36) et les caractéristiques de l'antenne (24, 28, 30).

9. Système d'alimentation électrique (2) d'un dispositif à alimenter (6) ; ledit système d'alimentation (2) comportant :
- au moins un générateur de puissance (4) apte à générer un signal d'alimentation ;
- une charge (19) comportant au moins un équipement relais (10, 12) ; ledit au moins un équipement relais (10, 12) comprenant au moins un quadripôle passif (26, 32, 36) et au moins une antenne (24, 28, 30) reliée audit au moins un quadripôle passif (26, 32, 36) ;
**caractérisé en ce que** le système d'alimentation (2) comporte un calculateur (18) et **en ce que** ledit générateur de puissance (4) comporte un variateur de fréquence (14) commandé par ledit calculateur (18) ; ledit calculateur (18) étant propre à mettre en œuvre le procédé d'identification selon l'une quelconque des revendications 1 à 8.

10. Système d'alimentation électrique (2) selon la revendication 9, dans lequel une charge de référence (16) ayant une impédance connue est connectée à la sortie du générateur de puissance (4) en série avec ledit au moins un équipement relais (10, 12).

11. Programme informatique comportant des instructions qui conduisent le système selon les revendications 9 ou 10 à mettre en œuvre le procédé d'identification selon l'une quelconque des revendications 1 à 8.

## Patentansprüche

1. Verfahren zur Erkennung des Vorhandenseins eines Fehlers einer Relaisvorrichtung in einem elektrischen Stromversorgungssystem (2) einer mit Strom zu versorgenden Vorrichtung (6), wobei das Stromversorgungssystem (2) mindestens einen Leistungsgenerator (4), der fähig ist, ein Stromversorgungssignal zu erzeugen, und eine Last (19), die mit einem Ausgang des Leistungsgenerators (4) verbunden ist, umfasst, wobei die Last (19) mindestens eine Relaisvorrichtung (10, 12) umfasst; wobei der Leistungsgenerator (4) einen Frequenzwandler (14) umfasst; wobei die Relaisvorrichtung (10, 12) mindestens einen passiven Quadrupol (26, 32, 36) und mindestens eine an den mindestens einen passiven Quadrupol (26, 32, 36) angebundene Antenne (24, 28, 30) beinhaltet; **dadurch gekennzeichnet, dass** das Erkennungsverfahren die folgenden Schritte beinhaltet:
a) Auswählen (52) einer charakteristischen Frequenz (fi, f1),
b) Bestimmen (54, 56, 58) der Impedanz (Zᵢ) der Last (19) am Ausgang des Leistungsgenerators (4), wenn das Stromversorgungssignal die ausgewählte charakteristische Frequenz (fi, f1) aufweist,
c) Wiederholen (60) der Schritte a) und b) für mehrere charakteristische Frequenzen (fi, f1), die sich voneinander unterscheiden,
d) Erkennen (88) des Vorhandenseins eines Fehlers auf der Grundlage mehrerer, für unterschiedliche charakteristische Frequenzen (fi, f1) bestimmter Impedanzen (Zᵢ),
wobei der Schritt der Erkennung (88) einen Schritt des Vergleichs (62) der bei einer gegebenen charakteristischen Frequenz (fi, f1) bestimmten Impedanz (Zᵢ) mit mindestens einem Schwellenwert (S₁^{H,} Sᵢ^{H;} S₁^{B,} Sᵢ^{B}) beinhaltet, wobei der mindestens eine Schwellenwert (S₁^{H,} Sᵢ^{H}; S₁^{B,} Sᵢ^{B}) zu der gegebenen charakteristischen Frequenz (fi, f1) gehört.

2. Verfahren zur Erkennung einer fehlerhaften Relaisvorrichtung in einem elektrischen Stromversorgungssystem (2) einer mit Strom zu versorgenden Vorrichtung (6), wobei das Stromversorgungssystem (2) mindestens einen Leistungsgenerator (4), der fähig ist, ein Stromversorgungssignal zu erzeugen, und eine Last (19), die mit einem Ausgang des Leistungsgenerators verbunden ist, umfasst, wobei die Last (19) mindestens zwei Relaisvorrichtungen (10, 12) umfasst; wobei der Leistungsgenerator (4) einen Frequenzwandler (14) umfasst; wobei jede Relaisvorrichtung (10, 12) mindestens einen passiven Quadrupol (26, 32, 36) und mindestens eine an den mindestens einen passiven Quadrupol (26, 32, 36) angebundene Antenne (24, 28, 30) beinhaltet; **dadurch gekennzeichnet, dass** das Erkennungsverfahren die folgenden Schritte beinhaltet:
a) Auswählen (52) einer charakteristischen Frequenz (fi, f1),
b) Bestimmen (54, 56, 58) der Impedanz (Zᵢ) der Last (19) am Ausgang des Leistungsgenerators (4), wenn das Stromversorgungssignal die ausgewählte charakteristische Frequenz (fi, f1) aufweist,
c) Wiederholen (60) der Schritte a) und b) für mehrere charakteristische Frequenzen (fi, f1), die sich voneinander unterscheiden,
d) Erkennen (90) der fehlerhaften Relaisvorrichtung (10, 12) auf der Grundlage mehrerer, für unterschiedliche charakteristische Frequenzen (fi, f1) bestimmter Impedanzen (Zᵢ),
wobei der Schritt der Erkennung (90) einen Schritt des Vergleichs (62) der bei einer gegebenen charakteristischen Frequenz (fi, f1) bestimmten Impedanz (Zᵢ) mit mindestens einem Schwellenwert (S₁^{H,} Sᵢ^{H;} S₁^{B,} Sᵢ^{B}) beinhaltet, wobei der mindestens eine Schwellenwert (S₁^{H,} Sᵢ^{H}; S₁^{B,} Sᵢ^{B}) zu der gegebenen charakteristischen Frequenz (fi, f1) gehört.

3. Verfahren zur Erkennung der Art von Fehler einer Relaisvorrichtung in einem elektrischen Stromversorgungssystem (2) einer mit Strom zu versorgenden Vorrichtung (6), wobei das Stromversorgungssystem (2) mindestens einen Leistungsgenerator (4), der fähig ist, ein Stromversorgungssignal zu erzeugen, und eine Last (19), die mit einem Ausgang des Leistungsgenerators (4) verbunden ist, umfasst, wobei die Last (19) mindestens eine Relaisvorrichtung (10, 12) umfasst; wobei der Leistungsgenerator (4) einen Frequenzwandler (14) umfasst; wobei die Relaisvorrichtung (10, 12) mindestens einen passiven Quadrupol (26, 32, 36) und mindestens eine an den mindestens einen passiven Quadrupol (26, 32, 36) angebundene Antenne (24, 28, 30) beinhaltet; **dadurch gekennzeichnet, dass** das Erkennungsverfahren die folgenden Schritte beinhaltet:
a) Auswählen (52) einer charakteristischen Frequenz (fi, f1),
b) Bestimmen (54, 56, 58) der Impedanz (Zᵢ) der Last (19) am Ausgang des Leistungsgenerators (4), wenn das Stromversorgungssignal die ausgewählte charakteristische Frequenz (fi, f1) aufweist,
c) Wiederholen (60) der Schritte a) und b) für mehrere charakteristische Frequenzen (fi, f1), die sich voneinander unterscheiden,
d) Erkennen (92) der Art von Fehler der Relaisvorrichtung (10, 12) auf der Grundlage mehrerer, für unterschiedliche charakteristische Frequenzen (fi, f1) bestimmter Impedanzen (Zᵢ),
wobei der Schritt der Erkennung (92) einen Schritt des Vergleichs (62) der bei einer gegebenen charakteristischen Frequenz (fi, f1) bestimmten Impedanz (Zᵢ) mit mindestens einem Schwellenwert (S₁^{H,} Sᵢ^{H;} S₁^{B,} Sᵢ^{B}) beinhaltet, wobei der mindestens eine Schwellenwert (S₁^{H,} Sᵢ^{H}; S₁^{B,} Sᵢ^{B}) zu der gegebenen charakteristischen Frequenz (fi, f1) gehört.

4. Erkennungsverfahren nach einem der Ansprüche 1 bis 3, das zusätzlich die folgenden Schritte beinhaltet:
e) Berechnen (70) der Differenz zwischen der bei einer gegebenen charakteristischen Frequenz (fi, f1) bestimmten Impedanz (Zᵢ) und der bei einer anderen charakteristischen Frequenz (fi-1, f1) bestimmten Impedanz (Zᵢ₋₁),
f) Vergleichen (72) der Differenz mit mindestens einem absoluten Schwellenwert (S₁^{AH}, Sᵢ^{AH;} S₁^{AB}, Sᵢ^{AB}), wobei der mindestens eine absolute Schwellenwert (S₁^{AH}, Sᵢ^{AH}; S₁^{AB}, Sᵢ^{AB}) für ein Paar, das die gegebene charakteristische Frequenz (fi, f1) und die andere gegebene charakteristische Frequenz (fi-1, f1) beinhaltet, spezifisch ist,
g) Wiederholen (78) der Schritte e) und f) für mehrere bestimmte Impedanzen (Zᵢ).

5. Erkennungsverfahren nach einem der Ansprüche 1 bis 4, wobei der Erkennungsschritt die folgenden Schritte beinhaltet:
h) Berechnen (80) des Quotienten aus einerseits der Differenz zwischen der bei einer gegebenen charakteristischen Frequenz (fi, f1) bestimmten Impedanz (Zᵢ) und der bei einer anderen gegebenen charakteristischen Frequenz (fi-1, f1) bestimmten Impedanz (Zᵢ₋₁) und andererseits einer Impedanz von der bei der gegebenen charakteristischen Frequenz bestimmten Impedanz (Zᵢ) und der bei der anderen gegebenen charakteristischen Frequenz bestimmten Impedanz (Zᵢ₋₁),
i) Vergleichen (82) des Ergebnisses des Berechnungsschritts h) mit mindestens einem relativen Schwellenwert (S₁^{RH}, Sᵢ^{RH}; S₁^{RB}, Sᵢ^{RB}), wobei der relative Schwellenwert (S₁^{RH}, Sᵢ^{RH}; S₁^{RB}, Sᵢ^{RB}) zu jedem Paar, das die gegebene charakteristische Frequenz (fi, f1) und die andere gegebene charakteristische Frequenz (fi-1, f1) beinhaltet, gehört, und
j) Wiederholen (85) der Schritte h) und i) für mehrere bestimmte Impedanzen (Zᵢ).

6. Erkennungsverfahren nach Anspruch 4 oder 5, das zusätzlich die folgenden Schritte umfasst:
j) Zuordnen (64, 74, 84) des Ergebnisses jedes Vergleichs zu einer Kategorie von Referenzkategorien,
k) Vergleichen (66, 76, 86) der in Schritt j) zugeordneten Kategorien mit Referenzkategorien.

7. Erkennungsverfahren nach einem der Ansprüche 1 bis 6, wobei das Stromversorgungssystem (2) eine Referenzlast (16) umfasst, die in Reihe mit den Relaisvorrichtungen (10, 12) mit dem Ausgang des Leistungsgenerators (4) verbunden ist, wobei die Referenzlast (16) eine bei mindestens einer charakteristischen Frequenz (fi, f1) bekannte Impedanz aufweist und wobei der Schritt des Bestimmens (54, 56, 58) der Impedanz (Zᵢ) der Last (19) die folgenden Schritte beinhaltet:
- Bestimmen (54) der Spannung (V₀) am Ausgang des Leistungsgenerators (4),
- Bestimmen (56) der Spannung (V₁) an den Anschlüssen der Last (19),
- Berechnen (58) der Differenz zwischen der am Ausgang des Leistungsgenerators (4) bestimmten Spannung (V₀) und der an den Anschlüssen der Last (19) bestimmten Spannung (V₁) und Bestimmen der Impedanz der Last (19) auf der Grundlage der Differenz und der Impedanz der Referenzlast (16).

8. Erkennungsverfahren nach einem der Ansprüche 1 bis 7, wobei die charakteristischen Frequenzen (fᵢ, f₁, f₂) in Abhängigkeit von mindestens einem von der Art der Schaltung jeder Relaisvorrichtung (10, 12), den Eigenschaften des mindestens einen passiven Quadrupols (26, 32, 36) und den Eigenschaften der Antenne (24, 28, 30) bestimmt werden.

9. Elektrisches Stromversorgungssystem (2) einer mit Strom zu versorgenden Vorrichtung (6); wobei das Stromversorgungssystem Folgendes (2) umfasst:
- mindestens einen Leistungsgenerator (4), der fähig ist, ein Stromversorgungssignal zu erzeugen;
- eine Last (19), die mindestens eine Relaisvorrichtung (10, 12) umfasst; wobei die mindestens eine Relaisvorrichtung (10, 12) mindestens einen passiven Quadrupol (26, 32, 36) und mindestens eine an den mindestens einen passiven Quadrupol (26, 32, 36) angebundene Antenne (24, 28, 30) beinhaltet;
**dadurch gekennzeichnet, dass** das Stromversorgungssystem (2) einen Rechner (18) umfasst und dass der Leistungsgenerator (4) einen Frequenzumwandler (14), der von dem Rechner (18) gesteuert wird, umfasst; wobei der Rechner (18) geeignet ist, um das Erkennungsverfahren nach einem der Ansprüche 1 bis 8 zu implementieren.

10. Elektrisches Stromversorgungssystem (2) nach Anspruch 9, wobei eine Referenzlast (16), die eine bekannte Impedanz aufweist, in Reihe mit der mindestens einen Relaisvorrichtung (10, 12) mit dem Ausgang des Leistungsgenerators (4) verbunden ist.

11. Computerprogramm, das Anweisungen umfasst, die bewirken, dass das System nach den Ansprüchen 9 oder 10 das Erkennungsverfahren nach einem der Ansprüche 1 bis 8 implementiert.

## Claims

1. Method for identifying the existence of a failure of a relay device in an electrical power supply system (2) of an apparatus (6) to be supplied with power, said power supply system (2) including at least one power generator (4) capable of generating a power signal and a load (19) connected to an output of the power generator (4), said load (19) including at least one relay device (10, 12); said power generator (4) including a variable frequency drive (14); said relay device (10, 12) comprising at least one passive quadripole (26, 32, 36) and at least one antenna (24, 28, 30) connected to said at least one passive quadripole (26, 32, 36); **characterised in that** said identification method comprises the steps of:
a) selecting (52) a characteristic frequency (fi, f1),
b) determining (54, 56, 58) the impedance (Zᵢ) of the load (19) at the output of the power generator (4) when the power signal has the selected characteristic frequency (fi, f1),
c) repeating (60) steps a) and b) for a plurality of characteristic frequencies (fi, f1) that are distinct from one another,
d) identifying (88) the existence of a failure from a plurality of impedances (Zᵢ) determined for different characteristic frequencies (fi, f1),
the identification step (88) comprising a step of comparing (62) the impedance (Zᵢ) determined at a given characteristic frequency (fi, f1) with at least one threshold (S₁^{H}, Sᵢ^{H}; S₁^{B}, Sᵢ^{B}), said at least one threshold (S₁^{H}, Sᵢ^{H}; S₁^{B}, Sᵢ^{B}) being specific to said given characteristic frequency (fi, f1).

2. Method for identifying a failed relay device in an electrical power supply system (2) of an apparatus (6) to be supplied with power, said power supply system (2) including at least one power generator (4) capable of generating a power signal and a load (19) connected to an output of the power generator, said load (19) including at least two relay devices (10, 12); said power generator (4) including a variable frequency drive (14); each relay device (10, 12) comprising at least one passive quadripole (26, 32, 36) and at least one antenna (24, 28, 30) connected to said at least one passive quadripole (26, 32, 36); **characterised in that** said identification method comprises the steps of:
a) selecting (52) a characteristic frequency (fi, f1),
b) determining (54, 56, 58) the impedance (Zᵢ) of the load (19) at the output of the power generator (4) when the power signal has the selected characteristic frequency (fi, f1),
c) repeating (60) steps a) and b) for a plurality of characteristic frequencies (fi, f1) that are distinct from one another,
d) identifying (90) the failed relay device (10, 12) from a plurality of impedances (Zᵢ) determined for different characteristic frequencies (fi, f1),
the identification step (90) comprising a step of comparing (62) the impedance (Zᵢ) determined at a given characteristic frequency (fi, f1) with at least one threshold (S₁^{H}, Sᵢ^{H}; S₁^{B}, Sᵢ^{B}), said at least one threshold (S₁^{H}, Sᵢ^{H}; S₁^{B}, Sᵢ^{B}) being specific to said given characteristic frequency (fi, f1).

3. Method for identifying the type of failure of a relay device in an electrical power supply system (2) of an apparatus (6) to be supplied with power, said power supply system (2) including at least one power generator (4) capable of generating a power signal and a load (19) connected to an output of the power generator (4), said load (19) including at least one relay device (10, 12); said power generator (4) including a variable frequency drive (14); said relay device (10, 12) comprising at least one passive quadripole (26, 32, 36) and at least one antenna (24, 28, 30) connected to said at least one passive quadripole (26, 32, 36); **characterised in that** said identification method comprises the steps of:
a) selecting (52) a characteristic frequency (fi, f1),
b) determining (54, 56, 58) the impedance (Zᵢ) of the load (19) at the output of the power generator (4) when the power signal has the selected characteristic frequency (fi, f1),
c) repeating (60) steps a) and b) for a plurality of characteristic frequencies (fi, f1) that are distinct from one another,
d) identifying (92) the type of failure of the relay device (10, 12) from a plurality of impedances (Zᵢ) determined for different characteristic frequencies (fi, f1),
the identification step (92) comprising a step of comparing (62) the impedance (Zᵢ) determined at a given characteristic frequency (fi, f1) with at least one threshold (S₁^{H}, Sᵢ^{H}; S₁^{B}, Sᵢ^{B}), said at least one threshold (S₁^{H}, Sᵢ^{H}; S₁^{B}, Sᵢ^{B}) being specific to said given characteristic frequency (fi, f1).

4. Identification method according to any one of claims 1 to 3, further comprising the steps of:
e) calculating (70) the difference between the impedance (Zᵢ) determined at a given characteristic frequency (fi, f1) and the impedance (Zᵢ₋₁) determined at another given characteristic frequency (fi-1, f1),
f) comparing (72) said difference with at least one absolute threshold (S₁^{AH}, Sᵢ^{AH}; S₁^{AB}, Sᵢ^{AB}), said at least one absolute threshold (S₁^{AH}, Sᵢ^{AH}; S₁^{AB}, Sᵢ^{AB}) being specific to a pair comprising said given characteristic frequency (fi, f1) and said other given characteristic frequency (fi-1, f1),
g) repeating (78) steps e) and f) for a plurality of determined impedances (Zᵢ).

5. Identification method according to any one of claims 1 to 4, wherein the identification step comprising the steps of:
h) calculating (80) the quotient between, on the one hand, the difference between the determined impedance (Zᵢ) at a given characteristic frequency (fi, f1) and the determined impedance (Zᵢ₋₁) at another given characteristic frequency (fi-1, f1), and on the other hand an impedance among the determined impedance (Zᵢ) at the given characteristic frequency and the determined impedance (Zᵢ₋₁) at said other given characteristic frequency,
i) comparing (82) said result of the calculation step h) with at least one relative threshold (S₁^{RH}, Sᵢ^{RH}; S₁^{RB}, Sᵢ^{RB}), said relative threshold (S₁^{RH}, Sᵢ^{RH}; S₁^{RB}, Sᵢ^{RB}) being specific to each pair comprising said given characteristic frequency (fi, f1) and said other given characteristic frequency (fi-1, f1), and
j) repeating (85) steps h) and i) for a plurality of determined impedances (Zᵢ).

6. Identification method according to claim 4 or 5, further including the steps of:
j) assigning (64, 74, 84) the result of each comparison to a category among reference categories
k) comparing (66, 76, 86) the categories assigned in step j) to reference categories.

7. Identification method according to any one of claims 1 to 6, wherein the power supply system (2) includes a reference load (16) connected to the output of the power generator (4) in series with the relay devices (10, 12), said reference load (16) having a known impedance at at least one characteristic frequency (fi, f1), and wherein the step of determining (54, 56, 58) the impedance (Zᵢ) of the load (19) comprises the steps of:
- determining (54) the voltage (V₀) at the output of the power generator (4),
- determining (56) the voltage (V₁) across the load (19),
- calculating (58) the difference between the voltage (V₀) determined at the output of the power generator (4) and the voltage (V₁) determined across the load (19), and determining the impedance of the load (19) from said difference and from the impedance of the reference load (16).

8. Identification method according to any one of claims 1 to 7, wherein said characteristic frequencies (fᵢ, f₁, f₂) are determined as a function of at least one element among the type of circuit of each relay device (10, 12), the characteristics of the at least one passive quadripole (26, 32, 36), and the characteristics of the antenna (24, 28, 30).

9. Electrical power supply system (2) of an apparatus to be supplied (6), said power supply system (2) including:
- at least one power generator (4) capable of generating a power signal;
- a load (19) including at least one relay device (10, 12), said at least one relay device (10, 12) comprising at least one passive quadripole (26, 32, 36) and at least one antenna (24, 28, 30) connected to said at least one passive quadripole (26, 32, 36); **characterised in that** the power supply system (2) includes a computer (18) and **in that** said power generator (4) includes a variable-frequency drive (14) controlled by said computer (18), said computer (18) being suitable for implementing the identification method according to any one of claims 1 to 8.

10. Electrical power supply system (2) according to claim 9, wherein a reference load (16) having a known impedance is connected to the output of the power generator (4) in series with said at least one relay device (10, 12).

11. Computer program including instructions which cause the system according to claims 9 or 10 to implement the identification method according to any one of claims 1 to 8.
